# EUROPEAN PATENT APPLICATION

(11) **EP 4 832 689 A1**
(43) Date of publication of application: **28.10.2026**
(21) Application number: 24916554.9
(22) Date of filing: 11.11.2024
(51) Int. Cl.: H10D 30/66

(54) **TRANSISTOR, CHIP, AND ELECTRONIC DEVICE**

(30) Priority: 12.01.2024 CN 202410052279
(71) Applicant: Huawei Technologies Co., Ltd., Shenzhen, Guangdong 518129 (CN)
(72) Inventor: HUANG, Hefu, Shenzhen, Guangdong 518129 (CN); XIAO, Zhuocong, Shenzhen, Guangdong 518129 (CN); HU, Xiang, Shenzhen, Guangdong 518129 (CN); DONG, Yaoqi, Shenzhen, Guangdong 518129 (CN); XU, Jeffrey Junhao, Shenzhen, Guangdong 518129 (CN)
(74) Representative: Huawei European IPR
(86) International application number: PCT/CN2024/131271
(87) International publication number: WO 2025/148504

(57) **Abstract**

Embodiments of this application disclose a transistor, a chip, and an electronic device. The transistor includes a substrate, a channel, a first electrode, a gate electrode, a second electrode, and a spacer layer. The channel is disposed on the substrate, the first electrode, the gate electrode, and the second electrode are stacked in a first direction, and the gate electrode is disposed around the channel. The first electrode is disposed on the substrate, and the first direction is a direction perpendicular to the substrate. The spacer layer is disposed between the first electrode and the gate electrode, the spacer layer includes a first spacer layer and a second spacer layer that are stacked in the first direction, a wet etch rate of the second spacer layer is lower than a wet etch rate of silicon dioxide SiO2, and a dielectric constant of the first spacer layer is less than a dielectric constant of the second spacer layer. In this way, corrosion resistance performance of the spacer layer is improved, and parasitic capacitance of the transistor is reduced, thereby improving device performance.

## Description

This application claims priority to Chinese Patent Application No. 202410052279.1, filed with the China National Intellectual Property Administration on January 12, 2024 and entitled "TRANSISTOR, CHIP, AND ELECTRONIC DEVICE", which is incorporated herein by reference in its entirety.

### TECHNICAL FIELD

Embodiments of this application relate to the semiconductor field, and in particular, to a transistor, a chip, and an electronic device.

### BACKGROUND

A channel of a vertical transport transistor (Vertical transport transistor, VTFET) is perpendicular to a wafer. By utilizing space in a vertical direction for the channel of the vertical transport transistor, the vertical transport transistor may be used in a scaled device. This helps reduce a contacted gate pitch (contacted gate pitch, CGP) and increase a transistor density in a chip.

To avoid a short circuit of the transistor, a spacer layer needs to be disposed between a gate of the transistor and a source or a drain at the bottom of the transistor, and the spacer layer needs to be resistant to corrosion caused by a subsequent wet etching process.

### SUMMARY

Embodiments of this application provide a transistor, a chip, and an electronic device, to reduce corrosion of a spacer layer caused by a wet etching process.

To achieve the foregoing objective, the following technical solutions are used in embodiments of this application.

According to a first aspect of embodiments of this application, a transistor is provided, including: a substrate, a channel, a first electrode, a gate electrode, a second electrode, and a spacer layer. The channel is disposed on the substrate, the first electrode, the gate electrode, and the second electrode are stacked in a first direction, and the gate electrode is disposed around the channel. The first electrode is disposed on the substrate, and the first direction is a direction perpendicular to the substrate. The spacer layer is disposed between the first electrode and the gate electrode, the spacer layer includes a first spacer layer and a second spacer layer that are stacked in the first direction, a wet etch rate of the second spacer layer is lower than a wet etch rate of silicon dioxide SiO2, and a dielectric constant of the first spacer layer is less than a dielectric constant of the second spacer layer. Therefore, a wet etch rate of the spacer layer is lower than the wet etch rate of silicon dioxide, so that when silicon dioxide attached to a surface of the channel is removed by using a wet etching process in a subsequent process, corrosion of the spacer layer by the wet etching process is reduced. This improves corrosion resistance performance of the spacer layer and thereby improves stability and uniformity of the spacer layer. In addition, the first spacer layer is made of a material with a low dielectric constant, to enable a total dielectric constant of the spacer layer to be less than a preset value. This reduces parasitic capacitance of a transistor and improves device performance.

In an optional implementation, a dielectric constant of the spacer layer is less than 7.6. When an equivalent dielectric constant K of the spacer layer is 7.6, it is equivalent to a condition that SiN is used for the entire spacer layer. In this embodiment of this application, a composite structure of two spacer layers is used. The first spacer layer is made of a material with a low dielectric constant, and the equivalent dielectric constant K of the spacer layer may be less than 7.6. Compared with a pure SiN spacer layer, the spacer layer has reduced parasitic capacitance and better performance.

In an optional implementation, a material of the first spacer layer includes SiO2, a material of the second spacer layer includes SiOx, and X is less than 2. Therefore, the first spacer layer may have a low dielectric constant, and the second spacer layer may have good corrosion resistance performance.

In an optional implementation, the first spacer layer is formed by atomic layer deposition, and the second spacer layer is formed by implanting an Si ion into a surface layer of the first spacer layer. This results in a simple process and easy formation and does not introduce any new element. Reliability, mobility, and source and drain resistivity of a dielectric layer will not be affected (due to thermal diffusion), nor will a front-end tool be contaminated and thereby a production line be affected.

In an optional implementation, the spacer layer further includes a third spacer layer and a fourth spacer layer, the third spacer layer is disposed between the first electrode and the first spacer layer, and the fourth spacer layer is disposed on a surface of the channel between the first electrode and the gate electrode. Therefore, the channel is better protected.

In an optional implementation, the third spacer layer and the fourth spacer layer are made of a same material as the second spacer layer. Therefore, the third spacer layer, the fourth spacer layer, and the second spacer layer use the same material and may be integrally formed, thereby reducing processing difficulty.

In an optional implementation, the material of the first spacer layer includes SiO2, silicon nitride SiN, SiOx, SiOyNz, silicon carbide SiC, calcium oxycarbide SiOC, silicon carbonitride SiCN, silicon carbon oxynitride SiCNO, silicon boronitride SiBN, and SiBCN, and the material of the second spacer layer includes: silicon nitride SiN, SiOx, SiOyNz, silicon carbide SiC, calcium oxycarbide SiOC, silicon carbonitride SiCN, silicon carbon oxynitride SiCNO, silicon boronitride SiBN, and SiBCN. X is less than 2. Therefore, the first spacer layer may have a low dielectric constant, and the second spacer layer may have good corrosion resistance performance.

In an optional implementation, the first spacer layer, the second spacer layer, the third spacer layer, and the fourth spacer layer are formed by deposition. Therefore, the first spacer layer, the second spacer layer, the third spacer layer, and the fourth spacer layer are formed in a same manner, thereby reducing process difficulty.

According to a second aspect of embodiments of this application, a transistor is provided, including: a substrate, a channel, a first electrode, a gate electrode, a second electrode, and a spacer layer. The channel is disposed on the substrate, the first electrode, the gate electrode, and the second electrode are stacked in a first direction, and the gate electrode is disposed around the channel. The first electrode is disposed on the substrate, and the first direction is a direction perpendicular to the substrate. A wet etch rate of the spacer layer is lower than a wet etch rate of silicon dioxide SiO2.

In an optional implementation, a dielectric constant of the spacer layer is less than 7.6.

In an optional implementation, a material of the spacer layer includes SiOx, and X is less than 2.

According to a third aspect of embodiments of this application, a chip is provided, where the chip includes the foregoing transistor.

In an optional implementation, the chip includes: a logic chip, an analog chip, a memory chip, or a static random access memory.

According to a fourth aspect of embodiments of this application, an electronic device is provided, including a circuit board and the foregoing chip, where the chip is disposed on the circuit board.

According to a fifth aspect of embodiments of this application, a transistor preparation method is provided. The method includes: etching a substrate to form a channel; forming a first electrode on the substrate; forming a spacer layer on the first electrode, where the spacer layer includes a first spacer layer and a second spacer layer that are stacked in a first direction, the first spacer layer is close to the first electrode, a wet etch rate of the second spacer layer is lower than a wet etch rate of silicon dioxide (SiO2), and the first direction is a direction perpendicular to the substrate; forming a dummy gate electrode on the spacer layer, where the dummy gate electrode is disposed around the channel; forming a second electrode on the dummy gate electrode; removing the dummy gate electrode; and forming a gate electrode between the first electrode and the second electrode.

In an optional implementation, a material of the first spacer layer includes SiO2, a material of the second spacer layer includes SiOx, and X is less than 2.

In an optional implementation, forming the spacer layer on the first electrode includes: depositing the first spacer layer on a surface of the first electrode and a surface of the channel; depositing a protective layer on the first spacer layer; etching the protective layer to enable a thickness of the protective layer on the first electrode to be less than a thickness of the protective layer on the channel; implanting an Si ion into the first spacer layer on the first electrode to form the second spacer layer; and removing the protective layer.

In an optional implementation, the spacer layer further includes a third spacer layer and a fourth spacer layer, the third spacer layer is disposed on a surface that is of the gate electrode and that is close to the first electrode, and the fourth spacer layer is disposed on a surface of the channel between the first electrode and the gate electrode.

In an optional implementation, a material of the first spacer layer includes SiO₂, silicon nitride SiN, SiOx, SiOyNz, silicon carbide SiC, calcium oxycarbide SiOC, silicon carbonitride SiCN, silicon carbon oxynitride SiCNO, silicon boronitride SiBN, and SiBCN, and a material of the second spacer layer includes: silicon nitride SiN, SiOx, SiOyNz, silicon carbide SiC, calcium oxycarbide SiOC, silicon carbonitride SiCN, silicon carbon oxynitride SiCNO, silicon boronitride SiBN, and SiBCN, and X is less than 2.

In an optional implementation, forming the spacer layer on the first electrode includes: depositing a sacrificial layer on a surface of the first electrode and a surface of the channel; depositing a protective layer on a surface of the sacrificial layer on the channel; etching the sacrificial layer on the first electrode, to enable the first electrode, the channel, the sacrificial layer, and the protective layer to be enclosed to form a groove; depositing the first spacer layer, the second spacer layer, the third spacer layer, and the fourth spacer layer in the groove, where the second spacer layer is formed on the surface of the first electrode, the third spacer layer is formed on the surface that is of the gate electrode and that is close to the first electrode, the fourth spacer layer is formed on the surface of the channel between the first electrode and the gate electrode, and the first spacer layer is formed in an area enclosed by the second spacer layer, the third spacer layer, and the fourth spacer layer; and removing the protective layer and the sacrificial layer.

### BRIEF DESCRIPTION OF DRAWINGS

FIG. 1 is a diagram of a structure of an electronic device according to an embodiment of this application;
FIG. 2 is a diagram of a structure of a circuit board according to an embodiment of this application;
FIG. 3 is a diagram of a structure of a transistor;
FIG. 4 is a diagram of a structure of a transistor according to an embodiment of this application;
FIG. 5 is a diagram of a structure of another transistor according to an embodiment of this application;
FIG. 6 is a diagram of a structure of still another transistor according to an embodiment of this application;
FIG. 7 is a diagram of a structure of an equivalent circuit of a bottom spacer layer shown in FIG. 6;
FIG. 8 is a curve diagram of an equivalent dielectric constant of a spacer layer varying with SiN thickness;
FIG. 9 is a flowchart of a transistor preparation method according to an embodiment of this application;
FIG. 10, FIG. 11, FIG. 12, FIG. 13, FIG. 14, FIG. 15, FIG. 16, and FIG. 17 are diagrams of product structures obtained after steps in FIG. 9 are performed;
FIG. 18 is a flowchart of another transistor preparation method according to an embodiment of this application;
FIG. 19 is a diagram of a product structure obtained after steps in FIG. 18 are performed;
FIG. 20 is a flowchart of still another transistor preparation method according to an embodiment of this application;
FIG. 21 is a diagram of a product structure obtained after steps in FIG. 20 are performed;
FIG. 22 is a flowchart of yet another transistor preparation method according to an embodiment of this application;
FIG. 23 is a diagram of a product structure obtained after steps in FIG. 22 are performed;
FIG. 24 is a flowchart of a spacer layer preparation method according to an embodiment of this application;
FIG. 25, FIG. 26, FIG. 27, FIG. 28, FIG. 29, and FIG. 30 are diagrams of product structures obtained after steps in FIG. 24 are performed;
FIG. 31 is a diagram of an ion implantation status according to an embodiment of this application;
FIG. 32 is a flowchart of a spacer layer preparation method according to an embodiment of this application; and
FIG. 33, FIG. 34, FIG. 35, FIG. 36, FIG. 37, and FIG. 38 are diagrams of product structures obtained after steps in FIG. 32 are performed.

### DESCRIPTION OF EMBODIMENTS

To make the objectives, technical solutions, and advantages of this application clearer, the following further describes this application in detail with reference to the accompanying drawings.

The terms "first" and "second" mentioned below are merely intended for a purpose of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more.

In addition, in this application, position terms such as "upper" and "lower" are defined relative to illustrative positions of components in the accompanying drawings. It should be understood that these direction terms are relative concepts and are used for descriptions and clarification of "relative to", and may vary based on changes of the positions of the components in the accompanying drawings.

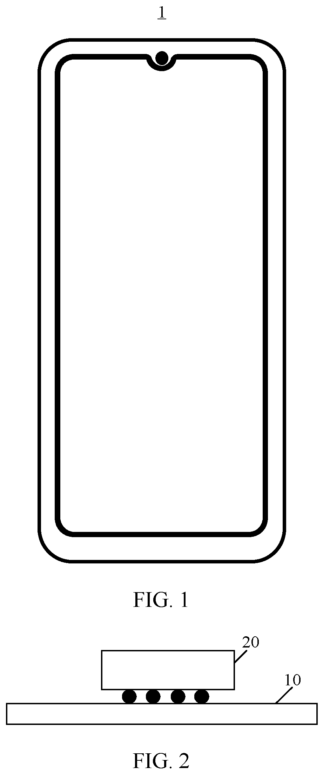

An embodiment of this application provides an electronic device. FIG. 1 is a diagram of a structure of an electronic device according to an embodiment of this application. As shown in FIG. 1, the electronic device 1 may be a mobile phone.

A specific form of the electronic device is not limited in this embodiment of this application. For example, the electronic device includes: a tablet computer (pad), a personal digital assistant (personal digital assistant, PDA), a television, an intelligent wearable product (for example, a smartwatch or a smart band), a virtual reality (virtual reality, VR) electronic device, an augmented reality (augmented reality, AR) electronic device, a small-sized rechargeable household appliance (for example, a soy milk maker or a vacuum cleaning robot), an unmanned aerial vehicle, a radar, an aerospace device, and a vehicle-mounted device.

FIG. 2 is a diagram of a structure of a circuit board according to an embodiment of this application. In some embodiments, the electronic device 1 in FIG. 1 includes, for example, a printed circuit board 10 shown in FIG. 2 and a chip 20 disposed on the circuit board. The chip may be a logic (Logic) chip, an analog chip, a memory chip, or a static random access memory (Static Random Access Memory, SRAM). A transistor is integrated in a core logic device of the logic chip, an input/output (Input/Output, I/O) device of the memory chip, or a selector of the static random access memory chip.

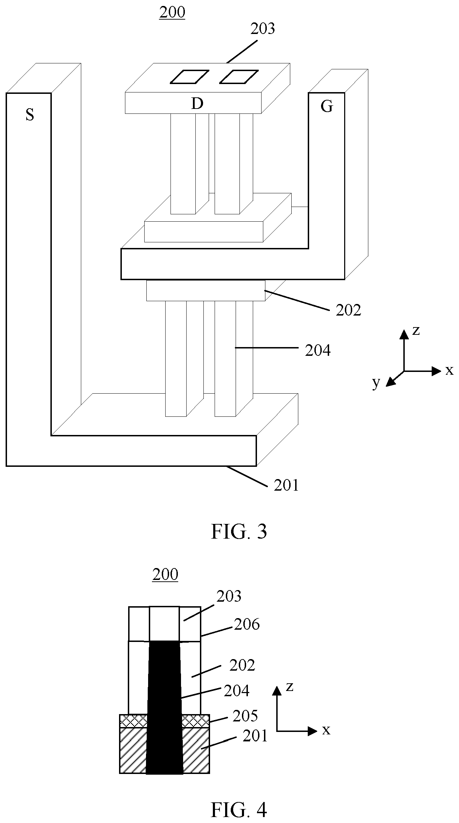

FIG. 3 is a diagram of a structure of a transistor. As shown in FIG. 3, the transistor 200 is a vertical transport transistor. The transistor includes: a substrate (not shown), a channel 204, a first electrode 201, a gate electrode 202, and a second electrode 203.

The channel 204 is disposed on the substrate, the first electrode 201, the gate electrode 202, and the second electrode 203 are stacked in a first direction (a z direction), and the first electrode 201 is disposed on the substrate. The first direction is a direction perpendicular to the substrate.

A material of the substrate includes silicon (Si).

Types of the first electrode 201 and the second electrode 203 are not limited in this embodiment of this application. In some embodiments, the first electrode 201 is a source electrode (S), the second electrode 203 is a drain electrode (D), and the gate electrode is G. In some other embodiments, the first electrode 201 is a drain electrode, and the second electrode 203 is a source electrode.

A doping type of the transistor is not limited in this embodiment. In some embodiments, the transistor includes: an N-metal-oxide-semiconductor (N-Metal-Oxide-Semiconductor, NMOS) transistor, a PMOS transistor, a junctionless (junctionless, JL) transistor, an inversion-mode (inversion mode, IM) transistor, a nanowire (nanowire, NW) transistor, and a nanosheet (nanosheet, NS) transistor.

The NMOS transistor includes an n-type dopant, for example, a dopant such as phosphorus, arsenic, antimony, bismuth, selenium, and tellurium, or a combination thereof.

The PMOS transistor includes a p-type dopant, for example, a dopant such as boron and methoxyboron difluoride, or a combination thereof.

In some embodiments, a material of the channel 204 includes: silicon (Si), silicon germanium (SiGe), and germanium (Ge).

In some embodiments, the transistor is a gate all around (Gate all around, GAA) transistor and is a transistor structure in which the entire channel 204 is wrapped by a ring-shaped gate, and the gate electrode 202 is disposed around the channel 204. A gate all around structure has a better gate control capability. A vertical gate all around structure is used in this embodiment of this application.

The gate all around structure is not limited in this embodiment of this application. The gate all around transistor includes at least one of a nanosheet transistor and a nanowire transistor.

The channel 204 of the vertical transport transistor provided in this embodiment of this application is perpendicular to the substrate, so that space in a vertical direction can be fully utilized, and the vertical transport transistor may be used in a scaled device. This helps reduce a contacted gate pitch and increase a transistor density in a chip.

FIG. 4 is a diagram of a structure of a transistor according to an embodiment of this application. With reference to FIG. 4 in combination with FIG. 3, the transistor 200 further includes a spacer layer. The spacer layer is divided into a bottom spacer layer 205 and a top spacer layer 206 (not shown in FIG. 3).

In some embodiments, the bottom spacer layer 205 is disposed at a junction between the first electrode 201 and the gate electrode 202, and the top spacer layer 206 is disposed at a junction between the gate electrode 202 and the second electrode 203.

For example, as shown in FIG. 4, the bottom spacer layer 205 is disposed between the first electrode 201 and the gate electrode 202 and around the channel 204. In another embodiment, the bottom spacer layer 205 may be disposed partially around the channel 204 and partially around the first electrode.

Correspondingly, in some embodiments, the top spacer layer 206 may be disposed between the second electrode 203 and the gate electrode 202 and around the channel 204. In another embodiment, the bottom spacer layer 205 may be disposed partially around the channel 204 and partially around the second electrode 203.

The spacer layer (205, 206) is a dielectric layer and may provide electrical isolation between the gate electrode 202 and the first electrode 201, to avoid a short circuit of the transistor.

To reduce corrosion of the spacer layer by a subsequent wet etching process, the spacer layer (205, 206) may be made of a corrosion-resistant material.

In some embodiments, a wet etch rate (wet etch rate, WER) of the spacer layer (205, 206) may be lower than a wet etch rate of silicon dioxide (SiO2). To be specific, corrosion resistance performance of the spacer layer (205, 206) is greater than corrosion resistance performance of silicon dioxide (SiO2).

With good electrical insulation, thermal stability and chemical stability, silicon dioxide (SiO2) is used for an electrical isolation layer and a mask layer, and may serve as a gate oxide layer in a transistor preparation process. In a subsequent process, a gate oxide layer (silicon dioxide) attached to a surface of the channel 204 may be removed by using a wet etching process. In this embodiment, it is limited that the wet etch rate of the spacer layer (205, 206) is lower than the wet etch rate of silicon dioxide (SiO2), so that when the gate oxide layer on the surface of the channel 204 is removed by using the wet etching process in the subsequent process, the spacer layer (205, 206) is more difficult to be corroded. This improves the corrosion resistance performance of the spacer layer (205, 206) and thereby improves stability and uniformity of the spacer layer (205, 206).

Forming processes of silicon dioxide (SiO2) includes: a thermal oxidation process, a plasma enhanced chemical vapor deposition (plasma enhanced chemical vapor deposition, PECVD) process, and the like. Silicon dioxide (SiO2) formed by using the thermal oxidation process has better corrosion resistance performance and a lower wet etch rate. In this embodiment, the wet etch rate of the spacer layer (205, 206) may be lower than a wet etch rate of silicon dioxide (SiO2) formed by using the thermal oxidation process.

Therefore, the wet etch rate of the spacer layer (205, 206) provided in this embodiment is lower than the wet etch rate of silicon dioxide (SiO2), so that when the silicon dioxide (SiO2) attached to the surface of the channel 204 is removed by using the wet etching process in the subsequent process, the corrosion of the spacer layer (205, 206) by the wet etching process is reduced. This improves the corrosion resistance performance of the spacer layer (205, 206) and thereby improves stability and uniformity of the spacer layer (205, 206).

A material of the spacer layer (205, 206) is not limited in this embodiment of this application. In some embodiments, the material of the spacer layer (205, 206) includes SiOx, and X in SiOx should be less than 2.

In some embodiments, SiOx may be formed by implanting an Si ion into SiO2.

In this embodiment, a wet etch rate of SiOx is lower than the wet etch rate of SiO2, and a difference between the wet etch rate of SiOx and the wet etch rate of SiO2 is caused by a chemical bond thereof. The chemical bond of SiO2 is an O-Si-O bond, while SiOx has an Si-O-Si bond. With respect to a bonding difference, SiOx and SiO2 can be distinguished by X-ray photoelectron spectroscopy (X-ray photoelectron spectroscopy, XPS) and Raman spectroscopy.

In some embodiments, the spacer layer (205, 206) may be made of a material with a low dielectric constant. For example, a dielectric constant of the spacer layer (205, 206) is less than 7.6.

The dielectric constant may be a relative dielectric constant, and is a measure of a response of a material to an electric field or a dielectric property of a material. A lower relative dielectric constant indicates a weaker charge storage capacity, and a higher relative dielectric constant indicates a stronger charge storage capacity.

A material with a lower relative dielectric constant (also referred to as a low-K material) generally has a dielectric constant less than 4.0. It is clear that a material with a higher relative dielectric constant (also referred to as a high-k material) has a dielectric constant greater than 4.0 and sometimes even close to or greater than 20.

A quantity of spacer layers (205, 206) is not limited in this embodiment of this application. In the foregoing embodiments, there is one spacer layer (205, 206), and in some other embodiments, there are a plurality of spacer layers (205, 206).

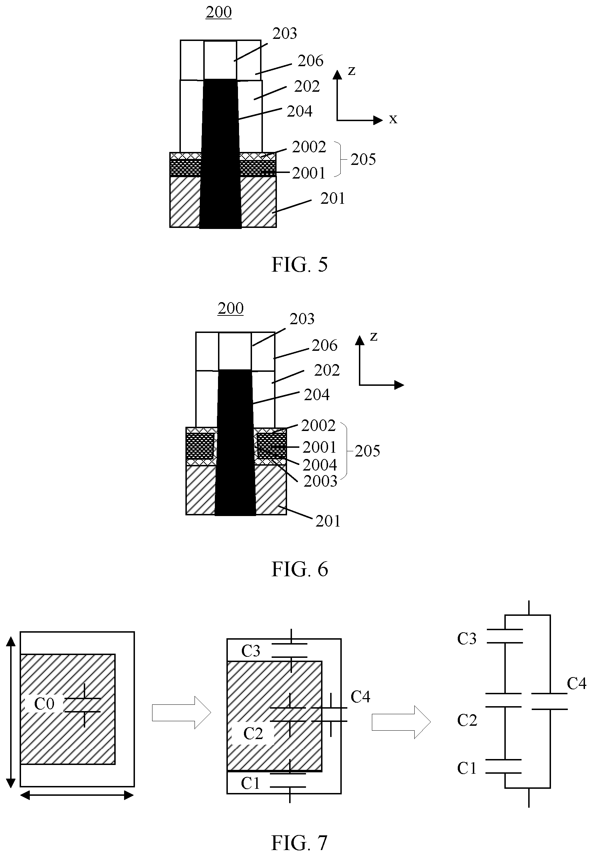

FIG. 5 is a diagram of a structure of another transistor according to an embodiment of this application. As shown in FIG. 5, the spacer layer 205 includes a first spacer layer 2001 and a second spacer layer 2002 that are stacked in the first direction.

For ease of description, the bottom spacer layer 205 is used as an example below. For a structure of the top spacer layer 206, refer to the descriptions of the bottom spacer layer 205.

In some embodiments, in the bottom spacer layer 205, the first spacer layer 2001 is disposed close to the first electrode 201, and the second spacer layer 2002 is disposed on a side that is of the first spacer layer 2001 and that is away from the first electrode 201.

A wet etch rate of the second spacer layer 2002 is lower than the wet etch rate of silicon dioxide (SiO2). To be specific, corrosion resistance performance of the second spacer layer 2002 is greater than the corrosion resistance performance of silicon dioxide (SiO2).

In some embodiments, the first spacer layer 2001 may be made of a low-K material, and the first spacer layer 2001 and the second spacer layer 2002 may be considered as two capacitors connected in parallel. In some embodiments, a dielectric constant of the first spacer layer may be less than a dielectric constant of the second spacer layer. A total dielectric constant of the first spacer layer 2001 and the second spacer layer 2002 is less than 7.6.

In some embodiments, a material of the first spacer layer 2001 includes SiO2, a material of the second spacer layer 2002 includes SiOx, and X is less than 2.

Therefore, two spacer layers (205, 206) are disposed, and the corrosion resistance performance of the second spacer layer 2002 close to the gate electrode 202 is better than the corrosion resistance performance of silicon dioxide (SiO2), so that corrosion of the spacer layer (205, 206) and the first electrode 201 caused by wet etching using hydrofluoric acid (Hydrofluoric Acid, HF) during preparation of the gate electrode 202 can be avoided. In addition, the first spacer layer 2001 is made of a low-K material, to enable a total dielectric constant of the spacer layer (205, 206) to be less than a preset value. This reduces parasitic capacitance of the transistor and improves device performance.

A process of the second spacer layer 2002 is not limited in this embodiment of this application. For example, the second spacer layer 2002 is formed by implanting an Si ion into a surface layer of the first spacer layer.

A process of the first spacer layer 2001 is not limited in this embodiment of this application. For example, the first spacer layer 2001 is formed by atomic layer deposition.

FIG. 6 is a diagram of a structure of still another transistor according to an embodiment of this application. As shown in FIG. 6, the bottom spacer layer 205 includes the first spacer layer 2001, the second spacer layer 2002, a third spacer layer 2003, and a fourth spacer layer 2004.

For descriptions of the first spacer layer 2001 and the second spacer layer 2002, refer to the foregoing embodiments. Details are not described herein again.

The first spacer layer 2001, the second spacer layer 2002, and the third spacer layer 2003 are stacked in the first direction. The first spacer layer 2001 is disposed close to the first electrode 201, the third spacer layer 2003 is disposed close to the gate electrode 202, and the fourth spacer layer 2004 is disposed on a surface of the channel 204 between the first electrode 201 and the gate electrode 202.

In some embodiments, the third spacer layer 2003 and the fourth spacer layer 2004 are made of a same material as the second spacer layer 2002.

The wet etch rate of the second spacer layer 2002 may be lower than the wet etch rate of silicon dioxide (SiO2).

The wet etch rate of the second spacer layer 2002 is lower than the wet etch rate of silicon dioxide (SiO2). To be specific, the corrosion resistance performance of the second spacer layer 2002 is greater than the corrosion resistance performance of silicon dioxide (SiO2).

In some embodiments, the first spacer layer 2001 may be made of a low-K material, and the first spacer layer 2001 and the second spacer layer 2002 may be considered as two capacitors connected in parallel. In some embodiments, the dielectric constant of the first spacer layer may be less than the dielectric constant of the second spacer layer, and the total dielectric constant of the first spacer layer 2001 and the second spacer layer 2002 is less than 7.6.

In some embodiments, the material of the first spacer layer 2001 includes SiO2, silicon nitride SiN, SiOx, SiOyNz, silicon carbide SiC, calcium oxycarbide SiOC, silicon carbonitride SiCN, silicon carbon oxynitride SiCNO, silicon boronitride SiBN, and SiBCN, and the material of the second spacer layer 2002 includes: silicon nitride SiN, SiOx, SiOyNz, silicon carbide SiC, calcium oxycarbide SiOC, silicon carbonitride SiCN, silicon carbon oxynitride SiCNO, silicon boronitride SiBN, and SiBCN. X is less than 2.

Therefore, a plurality of spacer layers are disposed, and the corrosion resistance performance of the second spacer layer 2002 close to the gate electrode 202 is better than the corrosion resistance performance of silicon dioxide (SiO2), so that corrosion of the spacer layer and the first electrode 201 caused by wet etching using hydrofluoric acid during preparation of the gate electrode 202 can be avoided. In addition, the first spacer layer 2001 is made of a low-K material, to enable a total dielectric constant of the spacer layer to be less than a preset value. This reduces parasitic capacitance of the transistor and improves device performance.

FIG. 7 is a diagram of a structure of an equivalent circuit of a bottom spacer layer shown in FIG. 6. As shown in FIG. 7, an overall capacitor C0 of the spacer layer shown in FIG. 6 may be equivalent to parallel connection between C4 on the right side and a serial connection structure on the left side, and a capacitor on the left side is formed by connecting C1, C2, and C3 in series. C4 may be equivalent to the fourth spacer layer 2004, C1 may be equivalent to the first spacer layer 2001, C2 may be equivalent to the second spacer layer 2002, and C3 may be equivalent to the third spacer layer 2003.

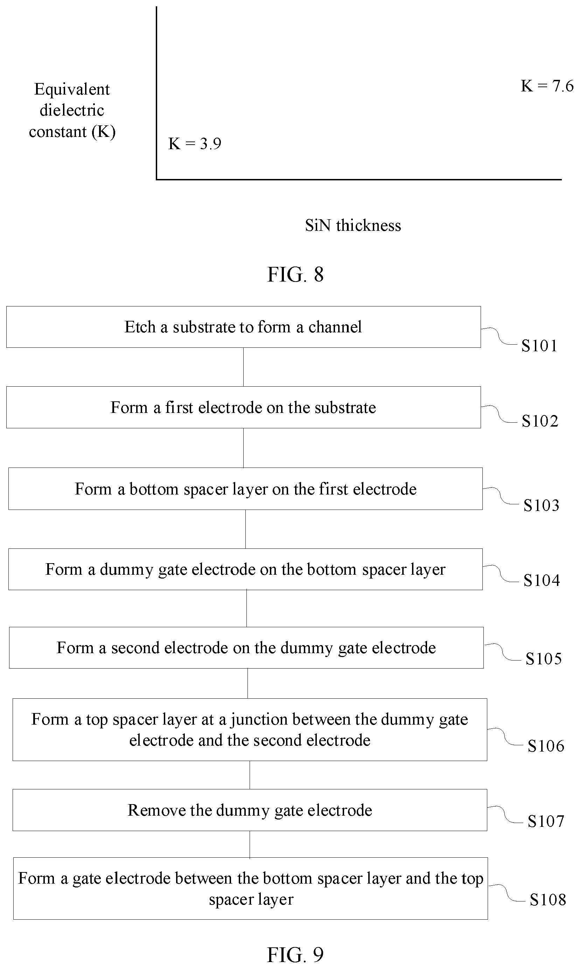

FIG. 8 is a curve diagram of an equivalent dielectric constant of a spacer layer varying with SiN thickness. As shown in FIG. 8, when the equivalent dielectric constant K of the spacer layer is 3.9, it is equivalent to a condition that SiO2 is used for the entire spacer layer; and when the equivalent dielectric constant K of the spacer layer is 7.6, it is equivalent to a condition that SiN is used for the entire spacer layer.

In this embodiment of this application, a composite structure of SiN and SiO2 is used. The dielectric constant of the first spacer layer is less than the dielectric constant of the second spacer layer, and the equivalent dielectric constant K of the spacer layer may be less than 7.6. Compared with a pure SiN spacer layer, the spacer layer has reduced parasitic capacitance and better performance.

A value of the dielectric constant K of the spacer layer is not limited in this embodiment. In some embodiments, the equivalent dielectric constant K of the spacer layer may be less than 5.

A forming process of the spacer layer is not limited in this embodiment of this application. In some embodiments, the first spacer layer 2001, the second spacer layer 2002, the third spacer layer 2003, and the fourth spacer layer 2004 are integrally formed by deposition.

This application further provides a transistor preparation method. FIG. 9 is a flowchart of a transistor preparation method according to an embodiment of this application. As shown in FIG. 9, the method includes the following steps.

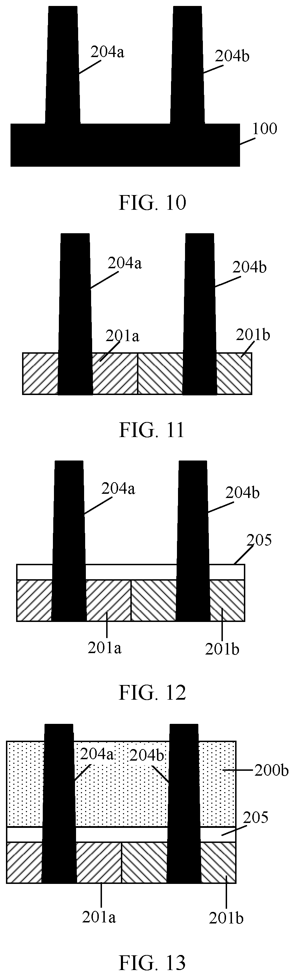

S101: Etch a substrate to form a channel (204a, 204b) shown in FIG. 10.

In some embodiments, a material of the substrate includes silicon (Si).

A structure of the substrate is not limited in this application. In some embodiments, a wafer with [100], [110], or another crystal orientation may be used as the substrate. A direction indicated by a connection line between any two atoms/molecules/ions in a unit cell is referred to as a crystal orientation. A lattice point O of the unit cell is taken as an origin, and coordinate axes X, Y, and Z are set through the origin O. Length of a lattice vector of the unit cell is taken as a length unit of the coordinate axes. A straight line OP is drawn through the origin O. A point P is required to be the closest to the point O, and the straight line OP is parallel to a to-be-determined crystal orientation AB. Three coordinate values of the point P are determined, and the three values are converted into minimum integers u, v, w that are enclosed in square brackets. [uvw] is a crystal orientation index of the to-be-determined crystal orientation AB. A size of the wafer is not limited in this embodiment.

The channel (204a, 204b) is perpendicular to the substrate. In this embodiment, the channel (204a, 204b) is disposed on the substrate in a Z direction.

S102: As shown in FIG. 11, form a first electrode (201a, 201b) on the substrate.

In some embodiments, the first electrode (201a, 201b) is a source electrode, and in some other embodiments, the first electrode (201a, 201b) is a drain electrode.

A doping type of the first electrode 201 is not limited in this embodiment. In some embodiments, 201a is an n-type doped layer. For example, 201a includes an n-type dopant, for example, a dopant such as phosphorus, arsenic, antimony, bismuth, selenium, and tellurium, or a combination thereof. In some embodiments, the substrate includes a well region (not shown) with a conductivity type different from that of 201a, and the well region extends from an upper surface of the substrate into the substrate. In some embodiments, 201a is located on the well region and in contact therewith. In some embodiments, the well region is a p-type well region.

In some other embodiments, 201b is a p-type doped layer. For example, 201b includes a p-type dopant, for example, a dopant such as boron and methoxyboron difluoride, or a combination thereof. In some embodiments, the substrate includes a well region (not shown) with a conductivity type different from that of 201b, and the well region extends from an upper surface of the substrate into the substrate. In some embodiments, 201b is located on the well region and in contact therewith. In some embodiments, the well region is an n-type well region.

S103: As shown in FIG. 12, form a bottom spacer layer 205 on the first electrode 201.

A wet etch rate of the bottom spacer layer 205 may be lower than a wet etch rate of silicon dioxide (SiO2). To be specific, corrosion resistance performance of the bottom spacer layer 205 is greater than corrosion resistance performance of silicon dioxide (SiO2). In addition, the bottom spacer layer 205 may be made of a material with a low dielectric constant. For example, a dielectric constant of the bottom spacer layer 205 is less than 7.6.

S104: As shown in FIG. 13, form a dummy gate electrode 200b on the bottom spacer layer 205.

In some embodiments, a material of the dummy gate electrode 200b includes amorphous silicon. The dummy gate electrode 200b may be formed by deposition.

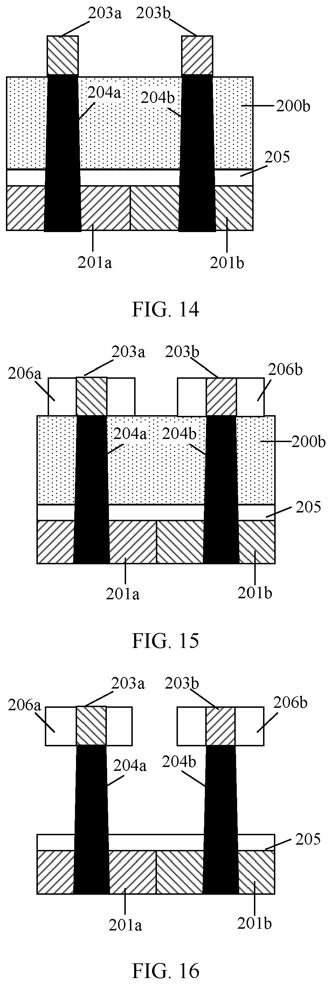

S105: As shown in FIG. 14, form a second electrode (203a, 203b) on the dummy gate electrode 200b.

In some embodiments, the second electrode (203a, 203b) is of a same doping type as the first electrode (201a, 201b).

When the first electrode (201a, 201b) is a source, the second electrode (203a, 203b) is a drain. When the first electrode (201a, 201b) is a drain, the second electrode (203a, 203b) is a source.

A material of the second electrode (203a, 203b) includes Si and SiGe.

A method for forming the second electrode (203a, 203b) is not limited in this embodiment. The second electrode (203a, 203b) may be formed by ion implantation, epitaxial growth, or the like.

S106: As shown in FIG. 15, form a top spacer layer (206a, 206b) at a junction between the second electrode (203a, 203b) and the dummy gate electrode 200b.

For a forming process of the top spacer layer (206a, 206b), refer to the bottom spacer layer 205. Details are not described herein again.

S107: As shown in FIG. 16, remove the dummy gate electrode 200b.

In some embodiments, a method of wet etching may be used for removal. A hydrofluoric acid solution may be used for etching.

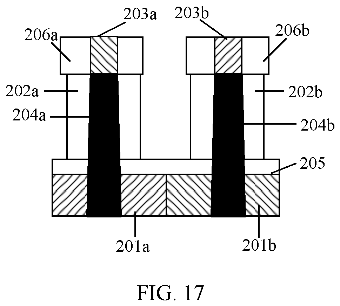

S108: As shown in FIG. 17, form a gate electrode (202a, 202b) between the bottom spacer layer 205 and the top spacer layer 206a, 206b.

The gate electrode 202a is disposed around the channel 204a, and the gate electrode 202b is disposed around the channel 204b.

In some embodiments, the gate electrode surrounds a part of the channel. In other embodiments, the gate electrode surrounds the entire channel.

In some examples of this embodiment, when the first electrode (201a, 201b) is an n-type doped layer, the channel (204a, 204b) is an n-type doped layer. In some embodiments, the channel (204a, 204b) includes an n-type dopant.

In some other examples of this embodiment, when the first electrode (201a, 201b) is a p-type doped layer, the channel (204a, 204b) is a p-type doped layer. In some embodiments, the channel (204a, 204b) includes a p-type dopant.

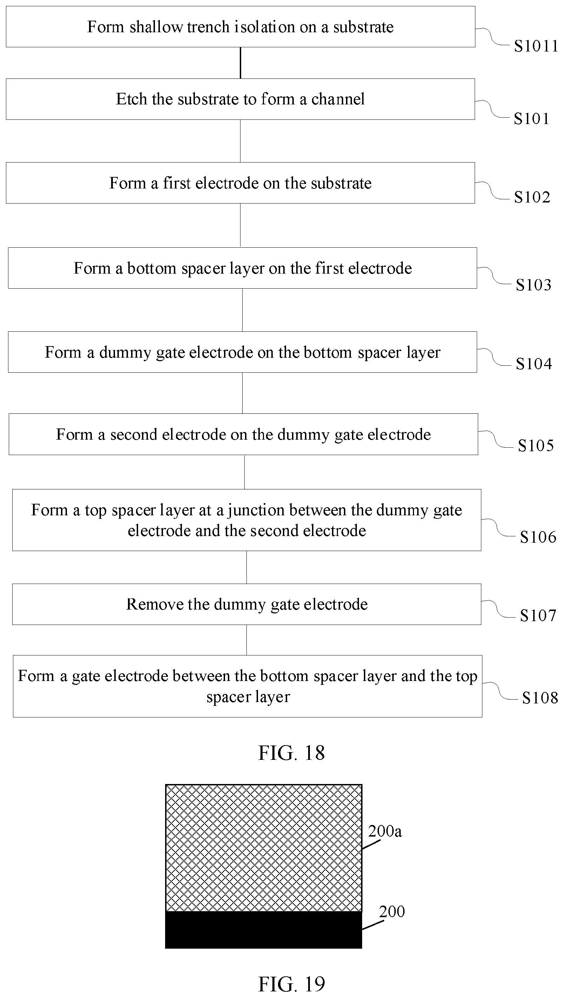

This application further provides a transistor preparation method. FIG. 18 is a flowchart of another transistor preparation method according to an embodiment of this application. As shown in FIG. 18, the method further includes the following steps before step S101.

S1011: As shown in FIG. 19, form shallow trench isolation (shallow trench isolation, STI) 200a on the substrate.

When the shallow trench isolation 200a is formed, a silicon nitride layer may be first deposited on the substrate, and then the silicon nitride layer is patterned to form a hard mask. Then, the substrate is etched to form a trench between adjacent transistor devices, and the trench is filled with oxide to form an element isolation structure. The shallow trench isolation 200a is, for example, parallel to an x direction, and the device in this application is formed on the substrate in the Z direction.

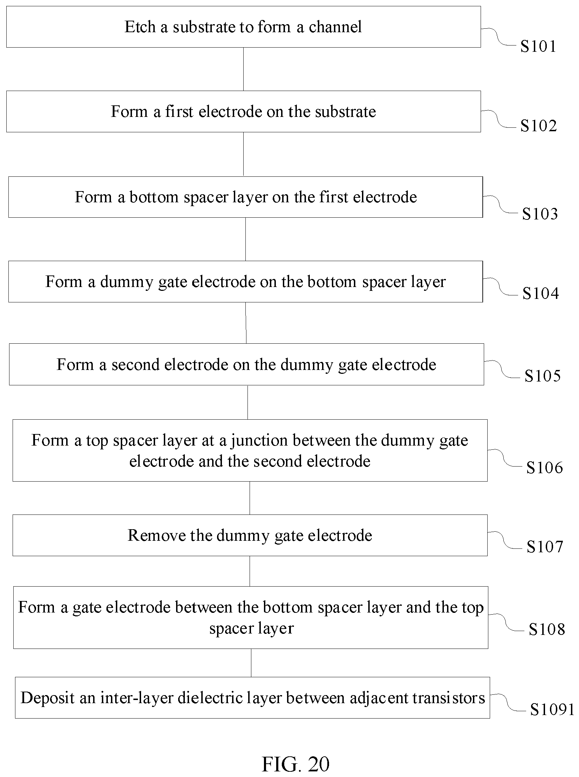

In some embodiments, an inter-layer dielectric (Inter-layer dielectric, ILD) layer 200c is disposed between adjacent transistors. This application further provides a transistor preparation method. FIG. 20 is a flowchart of still another transistor preparation method according to an embodiment of this application. As shown in FIG. 20, the method further includes the following steps after step S108.

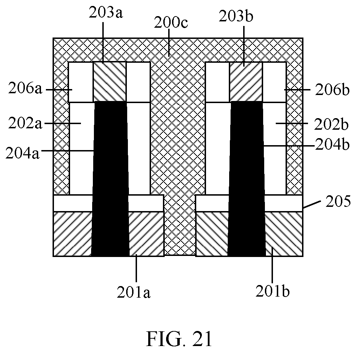

S1091: As shown in FIG. 21, deposit the inter-layer dielectric layer 200c between adjacent transistors.

Therefore, the inter-layer dielectric layer 200c may form isolation between devices. In some embodiments, a material of the inter-layer dielectric layer 200c includes: a dielectric material of silicon nitride, a dielectric material of silicon oxynitride, or another suitable insulating material.

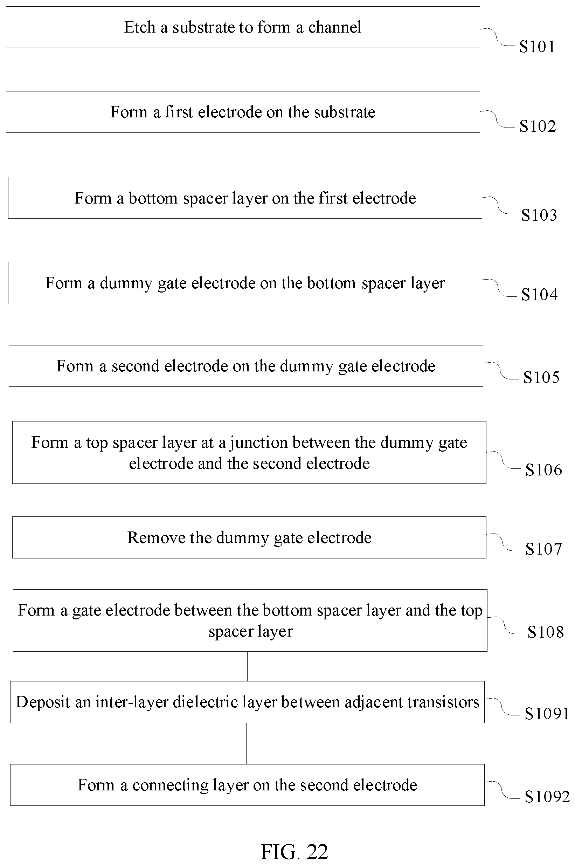

In some embodiments, the transistor further includes a connecting layer 2031. This application further provides a transistor preparation method. FIG. 22 is a flowchart of yet another transistor preparation method according to an embodiment of this application. As shown in FIG. 22, the method further includes the following steps after step S1091.

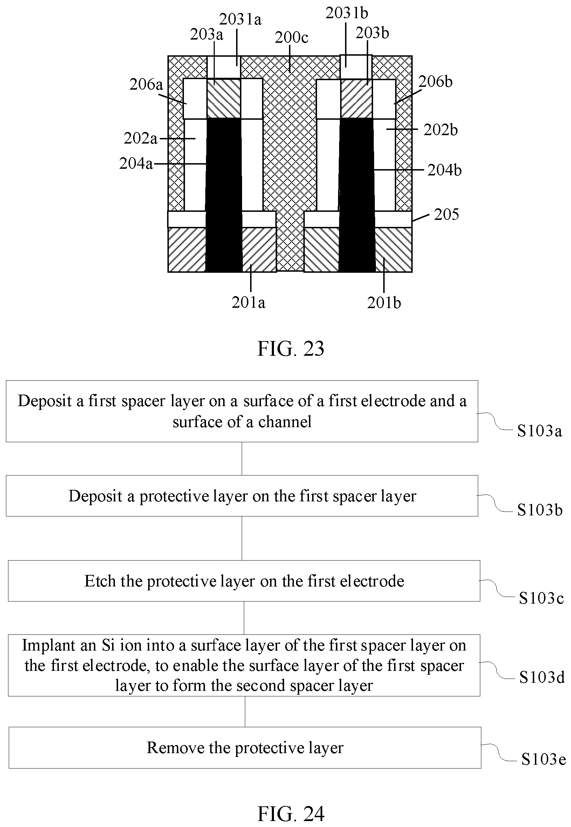

S1092: As shown in FIG. 23, form a connecting layer (2031a, 2031b) on the second electrode.

The connecting layer (2031a, 2031b) may be made of a conductive material such as metal. The connecting layer (2031a, 2031b) may be used to implement interconnection between transistors.

A structure of the spacer layer is not limited in this embodiment of this application.

In some embodiments, the spacer layer formed in step S103 is a single-layer structure.

In some other embodiments, the spacer layer formed in step S103 includes a first spacer layer 2001 and a second spacer layer 2002 that are stacked in a first direction, where the first spacer layer 2001 is close to the first electrode 201, and a wet etch rate of the second spacer layer 2002 is lower than the wet etch rate of silicon dioxide (SiO2).

The wet etch rate of the second spacer layer 2002 is lower than the wet etch rate of silicon dioxide (SiO2). To be specific, corrosion resistance performance of the second spacer layer 2002 is greater than the corrosion resistance performance of silicon dioxide (SiO2).

In some embodiments, a material of the channel 204 includes Si, a material of the first spacer layer 2001 includes SiO₂, a material of the second spacer layer 2002 includes SiOx, and X is less than 2.

In this embodiment, a wet etch rate of SiOx is lower than the wet etch rate of SiO2, and a difference between the wet etch rate of SiOx and the wet etch rate of SiO2 is caused by a chemical bond thereof. The chemical bond of SiO₂ is an O-Si-O bond, while SiOx has an Si-O-Si bond. With respect to a bonding difference, SiOx and SiO2 can be distinguished by X-ray photoelectron spectroscopy (X-ray photoelectron spectroscopy, XPS) and Raman spectroscopy.

Therefore, two spacer layers are disposed, and corrosion resistance performance of a spacer layer close to the gate electrode 202 is better than the corrosion resistance performance of silicon dioxide (SiO2), so that corrosion of the spacer layer and the first electrode 201 caused by wet etching using hydrofluoric acid during preparation of the gate electrode 202 can be avoided.

In some embodiments, the spacer layer may be made of a material with a low dielectric constant. For example, a dielectric constant of the spacer layer is less than 7.6.

The first spacer layer 2001 is formed by atomic layer deposition, and the second spacer layer 2002 is formed by ion implantation.

FIG. 24 is a flowchart of a spacer layer preparation method according to an embodiment of this application. As shown in FIG. 24, for example, a spacer layer includes a first spacer layer 2001 and a second spacer layer 2002. The spacer layer preparation method includes the following steps.

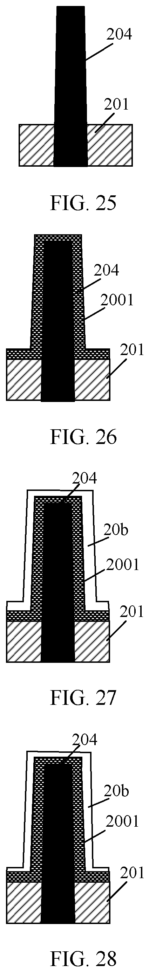

S103a: As shown in FIG. 26, deposit the first spacer layer 2001 on a surface of a first electrode 201 and a surface of a channel 204 shown in FIG. 25.

A material of the first spacer layer 2001 includes SiO2.

S103b: As shown in FIG. 27, deposit a protective layer 20b on the first spacer layer 2001.

A material of the protective layer 20b includes but is not limited to a material such as amorphous silicon (amorphous Si, aSi), titanium nitride TiN, and aluminum oxide Al₂O₃. The following uses aSi as an example only.

S103c: As shown in FIG. 28, etch the protective layer 20b.

A thickness of the protective layer 20b on the first electrode 201 and a thickness of the protective layer 20b on the channel 204 may be independently controlled, and the thickness of the protective layer 20b on the channel 204 is determined by a thickness of the protective layer 20b deposited in step S103b. The thickness of the protective layer 20b on the first electrode 201 is determined by an etching depth in step S103c. The thickness of the protective layer 20b on the first electrode 201 may be less than the thickness of the protective layer 20b on the channel 204.

In this embodiment, the protective layer 20b is disposed on the surface of the channel 204 to prevent SiO2 of the first spacer layer 2001 on the channel 204 from being changed into SiOx due to implantation of an Si ion. X is less than 2.

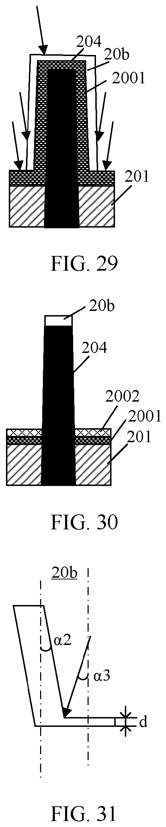

S103d: As shown in FIG. 29, implant an Si ion into a surface layer of the first spacer layer 2001 on the first electrode 201, to enable the surface layer of the first spacer layer 2001 to form the second spacer layer 2002.

During ion implantation, an ion implantation angle is generally tilted relative to a surface for implantation, that is, the ion is not implanted perpendicularly, so that a screening distance of the protective layer 20b on the first electrode 201 is different from a screening distance of the protective layer 20b on the channel 204.

Refer to FIG. 31. A total tilt angle (Total tiltangle) α1 of ion implantation equals a fin angle (fin angle) α2 plus an ion implantation tilt angle (implant tiltangle) α3.

The fin angle is an offset angle between the channel 204 and a vertical direction. The ion implantation tilt angle is an angle between the ion implantation angle and a normal of the surface for implantation.

In this embodiment, the fin angle is 3°, the ion implantation tilt angle is 7°, and the total tilt angle of ion implantation is 10°.$D \left(screen\right) = d \left(aSi\right) / sin \left(10°\right) \approx 5 d \left(aSi\right) .$

D(screen) is the screening distance. d(aSi) is a thickness of the protective layer 20b. sin(Total tiltangle) = D(screen)/d(aSi).

Based on the foregoing descriptions, when the ion implantation tilt angle is 7°, deposition of 4 nm of aSi provides a screening distance of 20 nm for blocking implantation. This is equivalent to a screening effect of a 20 nm protective layer 20b. The screening effect may be reflected by a blocking distance for ion implantation.

It should be noted that only SiO2 on a planar surface forms SiOx, and SiO2 on a side surface is removed.

In this embodiment, SiOx is formed by implanting an Si ion into SiO2.

In some other embodiments, SiOx may be formed by physical vapor deposition (Physical Vapor Deposition, PVD) or molecular beam epitaxy (Molecular beam epitaxy, MBE) deposition.

S103e: As shown in FIG. 30, remove the protective layer 20b.

The protective layer 20b and the channel 204 may be removed by etching.

In some embodiments, the protective layer 20b on an upper surface of the channel 204 forms SiOx, and SiOx may be smoothed by chemical mechanical polishing (Chemical Mechanical Polishing, CMP) when an inter-layer dielectric layer 200c is formed as mentioned above.

A simulation test is performed on a transistor formed in this embodiment, to obtain SiOx. For example, after the Si ion is implanted, a ratio of silicon Si to oxygen O in SiOx is 1:9.

For SiOx and SiO2 with a thickness of 13 nm, 6.4 nm of SiO2 remains after etching in 1:100 hydrofluoric acid for 2 minutes, and 12.87 nm of SiOx remains after etching in the same condition.

The spacer layer in this embodiment of this application is of a sandwich structure in which the first spacer layer and the second spacer layer are alternately disposed, and a material of the spacer layer uses only common elements N, Si, and O. SiOx only changes an element ratio of SiO2, without introducing any new element. Reliability, mobility, and source and drain resistivity of a dielectric layer will not be affected (due to thermal diffusion), nor will a tool be contaminated and thereby a production line be affected.

After step S103e, steps S104 to S108 continue to be performed, and a transistor shown in FIG. 5 may be obtained.

In the foregoing embodiment, the spacer layer includes the first spacer layer 2001 and the second spacer layer 2002. In some other embodiments, the spacer layer includes the first spacer layer 2001, the second spacer layer 2002, a third spacer layer 2003, and a fourth spacer layer 2004.

For descriptions of the first spacer layer 2001 and the second spacer layer 2002, refer to the foregoing embodiments. Details are not described herein again.

The first spacer layer 2001, the second spacer layer 2002, and the third spacer layer 2003 are stacked in the first direction. The first spacer layer 2001 is disposed close to the first electrode 201, the third spacer layer 2003 is disposed close to a gate electrode 202, and the fourth spacer layer 2004 is disposed on a surface of the channel 204 between the first electrode 201 and the gate electrode 202.

A wet etch rate of the second spacer layer 2002 is lower than a wet etch rate of silicon dioxide (SiO2).

The wet etch rate of the second spacer layer 2002 is lower than the wet etch rate of silicon dioxide (SiO2). To be specific, corrosion resistance performance of the second spacer layer 2002 is greater than corrosion resistance performance of silicon dioxide (SiO2).

Therefore, two spacer layers are disposed, and corrosion resistance performance of a spacer layer close to the gate electrode 202 is better than the corrosion resistance performance of silicon dioxide (SiO2), so that corrosion of the spacer layer and the first electrode 201 caused by wet etching using hydrofluoric acid during preparation of the gate electrode 202 can be avoided.

In some embodiments, the third spacer layer 2003 and the fourth spacer layer 2004 are made of a same material as the second spacer layer 2002. For example, the material of the first spacer layer 2001 includes SiO₂, and the material of the second spacer layer 2002 includes: silicon nitride SiN, SiOx, SiOyNz, silicon carbide SiC, calcium oxycarbide SiOC, silicon carbonitride SiCN, silicon carbon oxynitride SiCNO, silicon boronitride SiBN, and SiBCN. The first spacer layer 2001, the second spacer layer 2002, the third spacer layer 2003, and the fourth spacer layer 2004 are formed by deposition.

In some embodiments, the spacer layer may be made of a material with a low dielectric constant. For example, a dielectric constant of the spacer layer is less than 7.6.

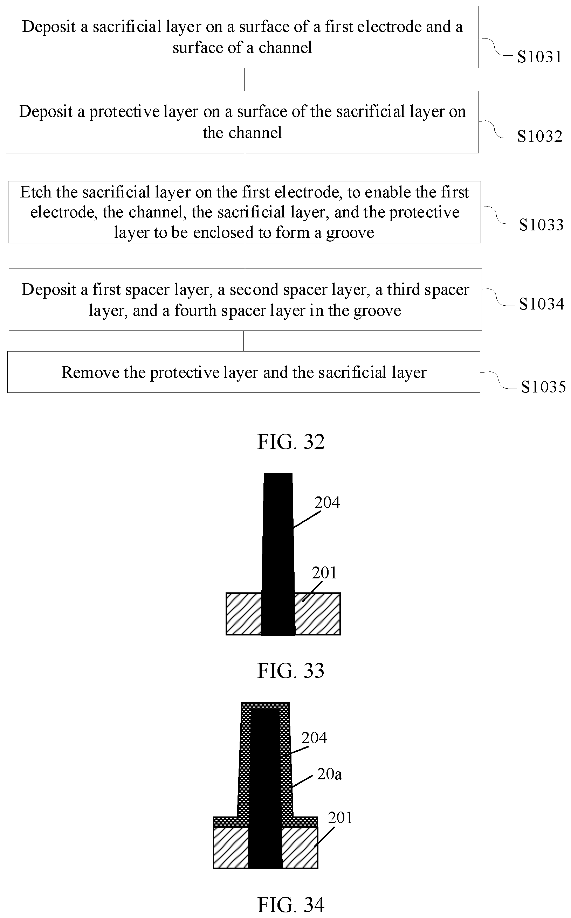

FIG. 32 is a flowchart of another spacer layer preparation method according to an embodiment of this application. In step S103, a bottom spacer layer is formed on a first electrode 201, including the following steps.

S1031: As shown in FIG. 34, deposit a sacrificial layer 20a on a surface of the first electrode 201 and a surface of a channel 204 shown in FIG. 33.

In some embodiments, a material of the sacrificial layer 20a includes SiO₂.

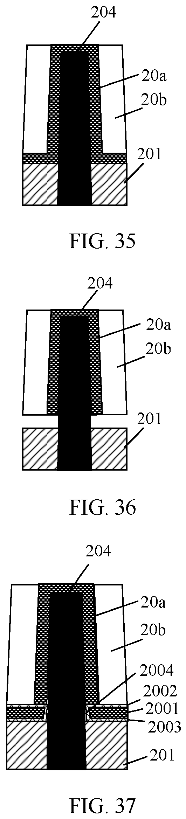

S1032: As shown in FIG. 35, deposit a protective layer 20b on a surface of the sacrificial layer 20a on the channel 204.

In some embodiments, a material of the protective layer 20b includes amorphous silicon aSi.

S1033: As shown in FIG. 36, etch the sacrificial layer 20a on the first electrode 201, to enable the first electrode 201, the channel 204, the sacrificial layer 20a, and the protective layer 20b to be enclosed to form a groove.

In some embodiments, the sacrificial layer 20a may be etched by dry etching, that is, plasma etching. During dry etching, a material may be removed by bombarding the surface of the sacrificial layer 20a by an excited plasma. For example, a chemical gas etching (certas) tool may be used for etching.

S1034: As shown in FIG. 37, deposit a first spacer layer 2001, a second spacer layer 2002, a third spacer layer 2003, and a fourth spacer layer 2004 in the groove.

A material of the second spacer layer 2002, the third spacer layer 2003, and the fourth spacer layer 2004 includes the following: A material of the first spacer layer 2001 includes SiO₂, silicon nitride SiN, SiOx, SiOyNz, silicon carbide SiC, calcium oxycarbide SiOC, silicon carbonitride SiCN, silicon carbon oxynitride SiCNO, silicon boronitride SiBN, and SiBCN, and the material of the second spacer layer 2002 includes: silicon nitride SiN, SiOx, SiOyNz, silicon carbide SiC, calcium oxycarbide SiOC, silicon carbonitride SiCN, silicon carbon oxynitride SiCNO, silicon boronitride SiBN, and SiBCN. The first spacer layer 2001, the second spacer layer 2002, the third spacer layer 2003, and the fourth spacer layer 2004 are formed by deposition. In this embodiment, an example in which the material of the second spacer layer 2002, the third spacer layer 2003, and the fourth spacer layer 2004 is SiN is used for description.

Depositing the first spacer layer 2001, the second spacer layer 2002, the third spacer layer 2003, and the fourth spacer layer 2004 in the groove includes:
forming the second spacer layer 2002 on the surface of the first electrode 201, forming the third spacer layer 2003 on a surface that is of a gate electrode 202 and that is close to the first electrode 201, and forming the fourth spacer layer 2004 on a surface of the channel 204 between the first electrode 201 and the gate electrode 202, where the second spacer layer 2002, the third spacer layer 2003, and the fourth spacer layer 2004 are enclosed to form a second groove.

Then, the first spacer layer 2001 is deposited in the second groove.

The material of the first spacer layer 2001 includes SiO₂.

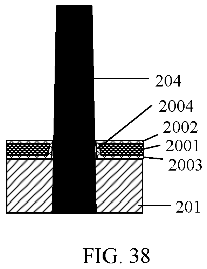

S1035: As shown in FIG. 38, remove the protective layer 20b and the sacrificial layer 20a.

The protective layer 20b and the sacrificial layer 20a may be removed by etching.

The spacer layer in this embodiment of this application has better thermal stability and good process and structural uniformity, and supports a subsequent possible high-temperature process.

The second spacer layer 2002, the third spacer layer 2003, and the fourth spacer layer 2004 are separately disposed on a surface of a junction between the first electrode and the gate electrode. Corrosion resistance performance of the second spacer layer 2002, the third spacer layer 2003, and the fourth spacer layer 2004 is better than corrosion resistance performance of silicon dioxide (SiO2), so that corrosion of the spacer layer and the first electrode 201 caused by wet etching using hydrofluoric acid during preparation of the gate electrode 202 can be avoided. In addition, the first spacer layer 2001 is made of a low-K material, to enable a total dielectric constant of the spacer layer to be less than a preset value. This reduces parasitic capacitance of a transistor and improves device performance.

In addition, a material of the spacer layer uses only common elements N, Si, and O, contains no metal, and does not introduce any new element. Reliability, mobility, and source and drain resistivity of a dielectric layer will not be affected (due to thermal diffusion), nor will a front-end tool be contaminated and thereby a production line be affected.

The first spacer layer 2001 may be selectively retained at the bottom, leaving no residue on a side wall of a silicon channel, and may be removed by using a common process.

After step S1035, steps S104 to S108 continue to be performed, and a transistor shown in FIG. 6 may be obtained.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A transistor, comprising a substrate, a channel, a first electrode, a gate electrode, a second electrode, and a spacer layer, wherein
the channel is disposed on the substrate, the first electrode, the gate electrode, and the second electrode are stacked in a first direction, the gate electrode is disposed around the channel, the first electrode is disposed on the substrate, and the first direction is a direction perpendicular to the substrate; and
the spacer layer is disposed between the first electrode and the gate electrode, the spacer layer comprises a first spacer layer and a second spacer layer that are stacked in the first direction, a wet etch rate of the second spacer layer is lower than a wet etch rate of silicon dioxide SiO2, and a dielectric constant of the first spacer layer is less than a dielectric constant of the second spacer layer.

2. The transistor according to claim 1, wherein a dielectric constant of the spacer layer is less than 7.6.

3. The transistor according to claim 1, wherein a material of the first spacer layer comprises SiO2, a material of the second spacer layer comprises SiOx, and X is less than 2.

4. The transistor according to claim 3, wherein the first spacer layer is formed by atomic layer deposition, and the second spacer layer is formed by implanting an Si ion into a surface layer of the first spacer layer.

5. The transistor according to any one of claims 1 to 4, wherein the spacer layer further comprises a third spacer layer and a fourth spacer layer, the third spacer layer is disposed between the first electrode and the first spacer layer, and the fourth spacer layer is disposed on a surface of the channel between the first electrode and the gate electrode.

6. The transistor according to claim 5, wherein the third spacer layer and the fourth spacer layer are made of a same material as the second spacer layer.

7. The transistor according to claim 6, wherein the material of the first spacer layer comprises SiO2, SiN, SiOx, SiOyNz, SiC, SiOC, SiCN, SiCNO, SiBN, and SiBCN, the material of the second spacer layer comprises SiN, SiOx, SiOyNz, SiC, SiOC, SiCN, SiCNO, SiBN, and SiBCN, and X is less than 2.

8. The transistor according to claim 7, wherein the first spacer layer, the second spacer layer, the third spacer layer, and the fourth spacer layer are formed by deposition.

9. A transistor, comprising a substrate, a channel, a first electrode, a gate electrode, a second electrode, and a spacer layer, wherein
the channel is disposed on the substrate, the first electrode, the gate electrode, and the second electrode are stacked in a first direction, the gate electrode is disposed around the channel, the first electrode is disposed on the substrate, and the first direction is a direction perpendicular to the substrate; and
a wet etch rate of the spacer layer is lower than a wet etch rate of silicon dioxide SiO2.

10. The transistor according to claim 9, wherein a dielectric constant of the spacer layer is less than 7.6.

11. The transistor according to claim 9 or 10, wherein a material of the spacer layer comprises SiOx, and X is less than 2.

12. A chip, wherein the chip comprises the transistor according to any one of claims 1 to 11.

13. The chip according to claim 12, wherein the chip comprises: a logic chip, an analog chip, a memory chip, or a static random access memory.

14. An electronic device, comprising a circuit board and the chip according to claim 12 or 13, wherein the chip is disposed on the circuit board.

15. A transistor preparation method, wherein the method comprises:
etching a substrate to form a channel;
forming a first electrode on the substrate;
forming a spacer layer on the first electrode, wherein the spacer layer comprises a first spacer layer and a second spacer layer that are stacked in a first direction, the first spacer layer is close to the first electrode, a wet etch rate of the second spacer layer is lower than a wet etch rate of silicon dioxide (SiO2), and the first direction is a direction perpendicular to the substrate;
forming a dummy gate electrode on the spacer layer, wherein the dummy gate electrode is disposed around the channel;
forming a second electrode on the dummy gate electrode;
removing the dummy gate electrode; and
forming a gate electrode on the spacer layer.

16. The method according to claim 15, wherein a material of the first spacer layer comprises SiO2, a material of the second spacer layer comprises SiOx, and X is less than 2.

17. The method according to claim 16, wherein forming the spacer layer on the first electrode comprises:
depositing the first spacer layer on a surface of the first electrode and a surface of the channel;
depositing a protective layer on the first spacer layer;
etching the protective layer, to enable a thickness of the protective layer on the first electrode to be less than a thickness of the protective layer on the channel;
implanting an Si ion into the first spacer layer on the first electrode to form the second spacer layer; and
removing the protective layer.

18. The method according to claim 15, wherein the spacer layer further comprises a third spacer layer and a fourth spacer layer, the third spacer layer is disposed on a surface that is of the gate electrode and that is close to the first electrode, and the fourth spacer layer is disposed on a surface of the channel between the first electrode and the gate electrode.

19. The method according to claim 18, wherein a material of the first spacer layer comprises SiO2, SiN, SiOx, SiOyNz, SiC, SiOC, SiCN, SiCNO, SiBN, and SiBCN, a material of the second spacer layer comprises SiN, SiOx, SiOyNz, SiC, SiOC, SiCN, SiCNO, SiBN, and SiBCN, and X is less than 2.

20. The method according to claim 18 or 19, wherein forming the spacer layer on the first electrode comprises:
depositing a sacrificial layer on a surface of the first electrode and a surface of the channel;
depositing a protective layer on a surface of the sacrificial layer on the channel;
etching the sacrificial layer on the first electrode, to enable the first electrode, the channel, the sacrificial layer, and the protective layer to be enclosed to form a groove;
depositing the first spacer layer, the second spacer layer, the third spacer layer, and the fourth spacer layer in the groove, wherein the second spacer layer is formed on the surface of the first electrode, the third spacer layer is formed on the surface that is of the gate electrode and that is close to the first electrode, the fourth spacer layer is formed on the surface of the channel between the first electrode and the gate electrode, and the first spacer layer is formed in an area enclosed by the second spacer layer, the third spacer layer, and the fourth spacer layer; and
removing the protective layer and the sacrificial layer.
